Europäisches Patentamt

European Patent Office

Office européen des brevets

(19)

(11) **EP 1 608 075 A2**

(12) **EUROPEAN PATENT APPLICATION**

(43) Date of publication:
 **21.12.2005 Bulletin 2005/51**

(51) Int Cl.7: **H03M 13/25, H03M 13/27**

(21) Application number: **05252491.5**

(22) Date of filing: **21.04.2005**

(84) Designated Contracting States:
 **AT BE BG CH CY CZ DE DK EE ES FI FR GB GR
 HU IE IS IT LI LT LU MC NL PL PT RO SE SI SK TR**
 Designated Extension States:
 **AL BA HR LV MK YU**

(30) Priority: **18.06.2004 GB 0413687**

(71) Applicant: **KABUSHIKI KAISHA TOSHIBA
 Tokyo 105-8001 (JP)**

(72) Inventor: **McNamara, Darren P.,
 Toshiba Research Europe Ltd.
 Bristol BS1 4ND (GB)**

(74) Representative: **Round, Edward Mark
 Marks & Clerk
 90 Long Acre
 London WC2E 9RA (GB)**

(54) **Bit interleaver for a mimo system**

(57)    An interleaver is described for use in MIMO transmission, for use in a transmitter apparatus for generating a multi-antenna output for transmission into a MIMO channel. The transmission apparatus comprises a data source for generating a block of coded bits for transmission in a first configuration, and the interleaver is operable to permute the bits into a second configuration, and to pass the permuted data to modulating means for modulating the bits in the second configuration into an OFDM frame for transmission. The interleaving means comprises mapping means for applying a mapping function to a first value describing the position of a bit in said first configuration. The mapping means is operable to generate a second value describing the position of the bit in the second position, the relationship between the second value and the first value being based on the product of the first value and a factor coprime with the number of bits in said block of data.

   A method of interleaving data, specific to MIMO transmission is also described, as is a receiver, a deinterleaver of such a receiver, and a method of receiving interleaved data.

FIGURE 4

**Description**

This invention is concerned with a MIMO communications system. More specifically, the invention concerns a bit interleaver for use in a MIMO communications system.

The performance of communication systems employing forward error correction (FEC) codes can be improved by bit interleaving. Bit interleaving involves creating a permutation of the coded bit stream so that bits that were adjacent to each other when leaving the encoder are as widely separated as possible (in various domains) during transmission over the channel. The motivation for this is that errors on communications channels (particularly wireless channels) occur in bursts, and so the effectiveness of the FEC code can be significantly improved if errors are distributed throughout the coded sequence. The distribution of any detection errors (prior to decoding) will occur when the received data stream is de-interleaved prior to entering the FEC decoder.

In a theoretical simulation of a bit interleaver, the interleaving operation performed by the bit interleaver is often set to be a purely random permutation of the coded sequence, with a new permutation being generated for every block transmitted. One problem with a purely random interleaver is that whilst it generates a good permutation on average over many realisations, it can sometimes generate a poor permutation where many consecutive bits output from the encoder are still adjacent (or close) to each other after the permutation. A second problem with a purely random interleaver is that in practice, de-interleaving a randomly interleaved signal is not possible, as there is no way for a receiver to be informed as to the interleaving permutation applied to the bit stream.

In practice, therefore, it is usual for operation of an interleaver to be governed by a mathematical definition specifying the generation of permutation patterns. One example of an interleaver whose operation is governed by an algorithm allowing for predictable de-interleaving is that which is disclosed in IEEE Standard 802.11a. The 802.11a wireless LAN standard specifies a bit interleaver which allocates bits to sub-carriers of an OFDM transmission such that consecutive bits are allocated to every third sub-carrier of the OFDM transmission, and also to constellation bit positions of alternating reliability.

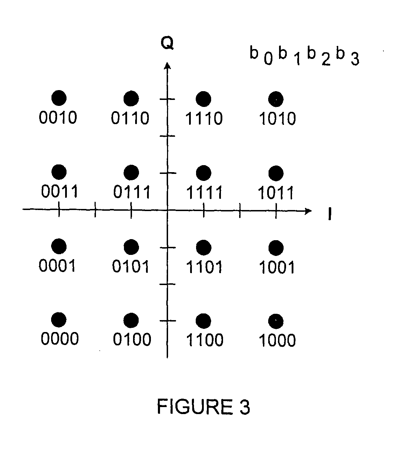

In Quadrature Amplitude Modulation (QAM) and associated coding techniques, a constellation of available symbols is defined, for which it is possible that reliability may vary depending on the symbol in use. Figure 3 illustrates a graph of a well-known QAM constellation, the 16QAM constellation. In this graph, dots plot symbols with respect to their in-phase (I) and quadrature (Q) components. There are 16 symbols in this constellation and so the symbols are mapped to values between 0000(binary) and 1111(binary) of a binary number $b_0b_1b_2b_3$.

In the general case, for a constellation that conveys M bits per symbol, denoted as the vector $[b_0,b_1,...,b_{M-1}]$, the reliability of a bit being successfully received can vary according to its position within the vector. The reliability of each bit position is dependent upon the exact bit-to-symbol mapping. Reliability depends on the Euclidean distance between symbols (as plotted on the graph of quadrature component against in-phase component of figure 3) and whether the symbols represent bit vectors with bits of common value. For example a certain transmitted symbol is in many cases most likely to be wrongly detected as one of its closest neighbouring symbols. If all neighbouring symbols represent the same bit value in a particular bit position then this bit position will be more reliable than if the bit values are different.

In the allocation illustrated in Figure 3, the bit mapping results in bits $b_0$ and $b_2$ having equal reliability, and bits $b_1$ and $b_3$ having equal reliability. The process of distinguishing between $b_0=0$ and $b_0=1$ is one of determining whether the in-phase component of the received signal is positive or negative. Similarly, the process of distinguishing between $b_2=0$ and $b_2=1$ is one of determining whether the quadrature component of the received signal is positive or negative. On the other hand, the process of determining the value of $b_1$ or $b_3$ is based on the amplitude of the in-phase or quadrature components, respectively.

Thus, information consistently transmitted in the same bit position may lead to a consistent lack of reliability of that particular information. Further, an interleaving process that transposes a sequence of bits to bit positions with the same level of reliability may not operate as well as an interleaver which does not. Thus, it is desirable to provide an interleaving process that is capable of transposing bits in data to be transmitted so that this problem can be ameliorated.

A feature of block de-interleavers of various constructions is the need to buffer a number of bits equal to the size of the interleaving block before de-interleaving can occur. The number of bits that must be buffered affects the decoding latency, as there is a delay in decoding whilst the receiver waits for all the bits in the interleaved block to be received. The interleaver described in the 802.11a standard is designed to minimise this latency. To achieve this, the 802.11a interleaver is designed for a block size equal to the number of coded bits that are conveyed in each OFDM symbol. Since 802.11a systems also allow for adaptive modulation and coding, the number of coded bits per OFDM symbol varies as the chosen constellation is changed. The definition of an interleaver for such a system must therefore be able to cope with this varying block size, and also the varying number of bits per symbol.

As input parameters, the 802.11a interleaver requires the number of coded bits per OFDM symbol $N_{CBPS}$ and the number of bits per sub-carrier $N_{BPSC}$. As quoted from the standard:

"All encoded data bits shall be interleaved by a block interleaver with a block size corresponding to the number of bits in a single OFDM symbol, $N_{CBPS}$. The interleaver is defined by a two-step permutation. The first permutation ensures that adjacent coded bits are mapped onto nonadjacent sub-carriers. The second ensures that adjacent coded bits are mapped alternately onto less and more significant bits of the constellation and, thereby, long runs of low reliability (LSB) bits are avoided.

"The index of the coded bit before the first permutation shall be denoted by *k; i* shall be the index after the first and before the second permutation; and *j* shall be the index after the second permutation, just prior to modulation mapping.

"The first permutation is defined by the rule

$$i = (N_{CBPS}/16)(k \bmod 16) + floor(k/16)$$

$$k = 0,1,..., N_{CBPS}\text{-}1$$

"The function *floor*(.) denotes the largest integer not exceeding the parameter.

"The second permutation is defined by the rule

$$j = s \times floor(i/s) + (i + N_{CBPS} - floor(16 \times i/N_{CBPS}))\bmod s$$

$$i = 0,1,..., N_{CBPS}\text{-}1$$

"The value of s is determined by the number of coded bits per subcarrier, $N_{BPSC}$, according to $s = max(N_{BPSC}/2,1)$."

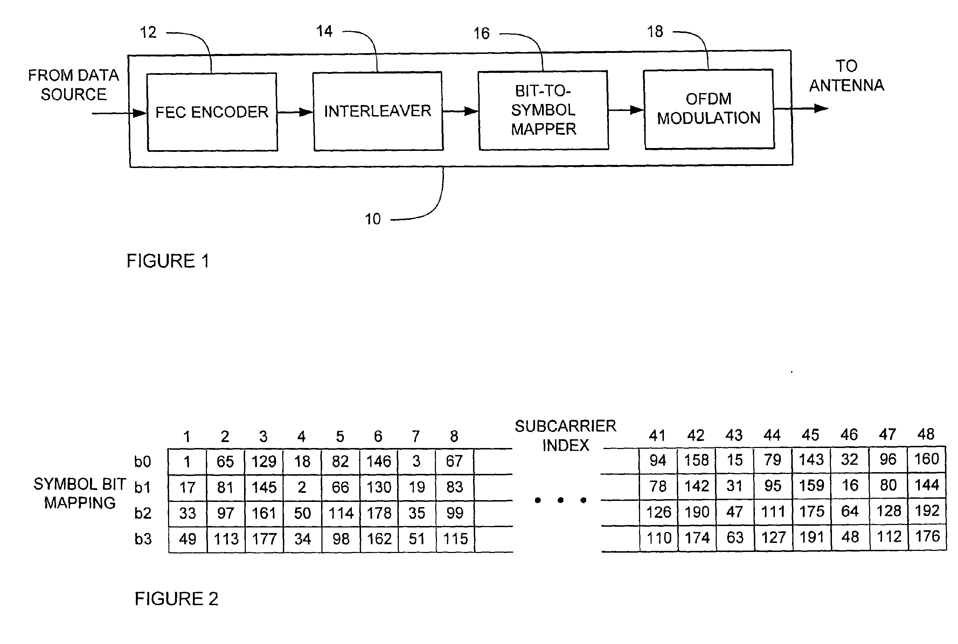

The exact definition of an interleaver (and the location of the bits when they then get sent over the channel) depends upon the manner in which bits are subsequently processed and allocated to sub-carriers or bit positions within a symbol. In the case of 802.11a, an interleaver is designed as described above based on a transmitter illustrated schematically in Figure 1. The transmitter 10 comprises a FEC encoder 12 which feeds encoded data to an interleaver 14 operable in accordance with the algorithm set out above. The interleaver 14 outputs an interleaved stream of bits to a bit-to-symbol mapper 16 which then outputs symbols to an OFDM modulator 18 which generates and outputs OFDM symbols to a suitable antenna into the channel.

In this example, bits output from the FEC encoder are interleaved in blocks of $N_{CBPS}$, groups of $N_{BPSC}$ consecutive bits are then assigned to bit positions $b_0$ to $h_{NBPSC-1}$ of a single symbol, and then finally these symbols are allocated across the data carrying sub-carriers of an OFDM symbol in sequence. An example of the resulting bit allocations for a single OFDM symbol for a system using 16QAM modulation is shown in Figure 2. It can be seen that adjacent bits are allocated to every third subcarrier and that they alternate between bit positions $b_0$ and $b_1$ or between $b_2$ and $b_3$.

It is now desirable to develop systems which harness Multiple Input, Multiple Output (MIMO) technologies, also including an interleaver. However, the interleaver described above is not directly applicable when multi-antenna transmissions are employed.

Thus, it is an object of this invention to provide an interleaver for use in a MIMO transmitter. It is a further object of the invention to provide a de-interleaver for use in a MIMO receiver.

According to a first aspect of the invention, a multi-antenna transmitter comprises an interleaver for interleaving encoded data, the interleaver being operable to map a bit of a given index position of a known plurality of available positions in a space time block of data to an interleaved position on said block, the interleaver being operable to apply a modulo operation on the earlier referenced index position in order to derive the latter referenced index position, and to allocate said bit to said latter index position.

The modulo operation may comprise the determination of one of its inputs by multiplying the original index position by a fixed integer value that is co-prime with the number of bits in the interleaver block. The modulo operation may additionally comprise of the addition of a second fixed integer value to the result of the first operation. The second fixed integer value may be different from the first. The modulus of the modulo operation is preferably equal to the number of bits in the interleaver block.

According to a second aspect of the invention, an interleaver for use in a multi-antenna transmitter comprises means for multiplying an index referencing a bit input to the interleaver block by a co-prime of the number of bits in said interleaver block, means for constraining the resultant product to one of a set of valid values for an index referencing said bit in an interleaved position, to provide a revised index for said bit in said interleaver block, and means for allocating said bit to a position in said interleaver block corresponding with said revised index.

According to a third aspect of an invention, a method of transmitting a signal comprises an interleaving step wherein bits in an interleaver block are reassigned positions, said interleaving step comprising applying, to an index for a bit in said interleaver block, a multiplication by a factor which is co-prime with respect to the number of bits in said interleaver block, and applying a modulo function to ensure that the resultant product is in the range of values corresponding to the number of possible index positions in said interleaver block.

The modulo operation is preferably with regard to the number of bits in the interleaver block.

According to a fourth aspect of the invention, a method of processing data for a MIMO transmission comprises an interleaving step wherein bits in an interleaver block are reassigned positions, said interleaving step comprising applying, to an index for a bit input to said interleaver block, a multiplication by a factor which is co-prime with respect to the number of bits in said interleaver block, applying a modulo function to ensure that the resultant product is in the range of values corresponding to the number of possible index positions in said interleaver block, and reassigning bits to said interleaver block on the basis of said resultant revised indices.

A fifth aspect of the invention provides transmitter apparatus for generating a multi-antenna output for transmission into a MIMO channel, the apparatus comprising a data source for generating a coded block of bits for transmission in a first configuration, interleaving means for permuting the bits into a second configuration, and means for modulating the bits in said second configuration into an OFDM frame for transmission, the interleaving means comprising mapping means for applying a mapping function to a first value describing the position of a bit in said first configuration, said mapping means being operable to generate a second value describing the position of said bit in said second position, the relationship between the second value and said first value being based on the product of the first value and a factor co-prime with the number of bits in said block of data.

The mapping means may be operable to perform a mapping function to determine the second value.

Alternatively, the mapping means may be operable to retrieve a second value from a stored set of prepared second values. The stored set may be stored in a look-up table.

The transmitter may be operable to transmit data in accordance with a selected one of a plurality of available transmission modes, each offering the facility to transmit a corresponding number of bits in an OFDM symbol. In that case, the apparatus may comprise a corresponding plurality of look-up tables, each look-up table storing a set of prepared second values.

The mapping means may be operable to apply a modulo to said second value such that said second value is within a range of permitted values for describing said second position.

According to a sixth aspect of the invention, receiving apparatus for receiving a MIMO transmission transmitted by a transmitter in accordance with any preceding aspect of the invention, includes de-interleaving means capable of de-interleaving data received on a MIMO transmission, the de-interleaving means being operable to map second values, identifying the position of a bit in a block of received data, back to first values identifying the position of bits in the block as generated by the transmitting apparatus.

The de-interleaving means may include a stored set of first values from which the de-interleaving means is operable to select one on the basis of a bit in a position identified by a second value. The de-interleaving means may comprise a look-up table in which the stored set is stored.

The de-interleaving means may comprise a plurality of look-up tables, each corresponding to a transmission mode, storing respective sets of first values from which one is selected, in use of the de-interleaving means, on the basis of the transmission mode in which received data is received and the second value corresponding to the position of a bit in a block of received data.

A communications system may be provided comprising a transmitter apparatus in accordance with any aspect of the invention and an appropriately configured receiver.

A seventh aspect of the invention provides a method of generating a multi-antenna output for transmission into a MIMO channel, comprising generating a block of bits for transmission in a first configuration, permuting the bits into a second configuration, and modulating the bits in said second configuration into an OFDM frame for transmission, the step of permuting comprising mapping a first value describing the position of a bit in said first configuration, to a second value describing the position of said bit in said second position, wherein the relationship between the second value and said first value is based on the product of the first value and a factor co-prime with the number of bits in said block of data.

The step of mapping may comprise performing a mapping function to determine said second value.

The step of mapping may comprise retrieving a second value from a stored set of prepared second values. The stored set may be stored in a look-up table.

In a transmitter operable to transmit data in accordance with a selected one of a plurality of available transmission modes, each offering the facility to transmit a corresponding number of coded bits in an OFDM symbol, the method may comprise selecting one of a corresponding plurality of look-up tables, each look-up table storing a set of prepared second values.

The mapping step may comprise applying a modulo to the second value such that the second value is within a range of permitted values for describing said second position.

A eighth aspect of the invention provides a method of receiving a MIMO transmission transmitted by a transmission method in accordance with the seventh aspect of the invention, including de-interleaving data received on a MIMO transmission, the step of de-interleaving comprising mapping a second value identifying the position of a bit in a block of received data, to a first value identifying the position of bits in the block as generated by the transmission method.

The step of de-interleaving may include selecting one of a stored set of first values on the basis of a bit in a position identified by a second value. The stored set may be stored in a look-up table.

The step of de-interleaving preferably comprises selecting a look-up table, from a plurality of look-up tables, each corresponding to a transmission mode and storing respective sets of first values, on the basis of the transmission mode in which received data is received and determining a first value corresponding to the position of said bit in said first configuration as generated in said transmission method, from said selected look-up table on the basis of the second value corresponding to the position of said bit in a block of received data.

Further aspects, preferred features and advantages of the invention will become apparent from the following description of a specific embodiment of a transmitter, an interleaver in the transmitter, a receiver for use with the transmitter, and a de-interleaver in the receiver, all in accordance with aspects of the present invention, will now be described with reference to the accompanying drawings, in which:

Figure 1 is a schematic diagram of an exemplary transmitter data processor including an interleaver known in the art;

Figure 2 is a diagram showing data allocation using an interleaver in accordance with the example illustrated in figure 1;

Figure 3 is a diagram showing a 16QAM constellation for use in illustrating the field of the present invention;

Figure 4 is a schematic diagram of a communications system including a transmitter with an interleaver in accordance with a specific embodiment of the invention and a receiver with a corresponding de-interleaver;

Figure 5 is a schematic diagram of a transmitter data processor of the transmitter illustrated in figure 4, including an interleaver;

Figure 6 is a flow diagram of a process of interleaving data performed in the interleaver illustrated in figure 5; and

Figure 7 is a diagram showing the result of data allocation using an interleaver in accordance with the embodiment of the invention illustrated in figure 4.

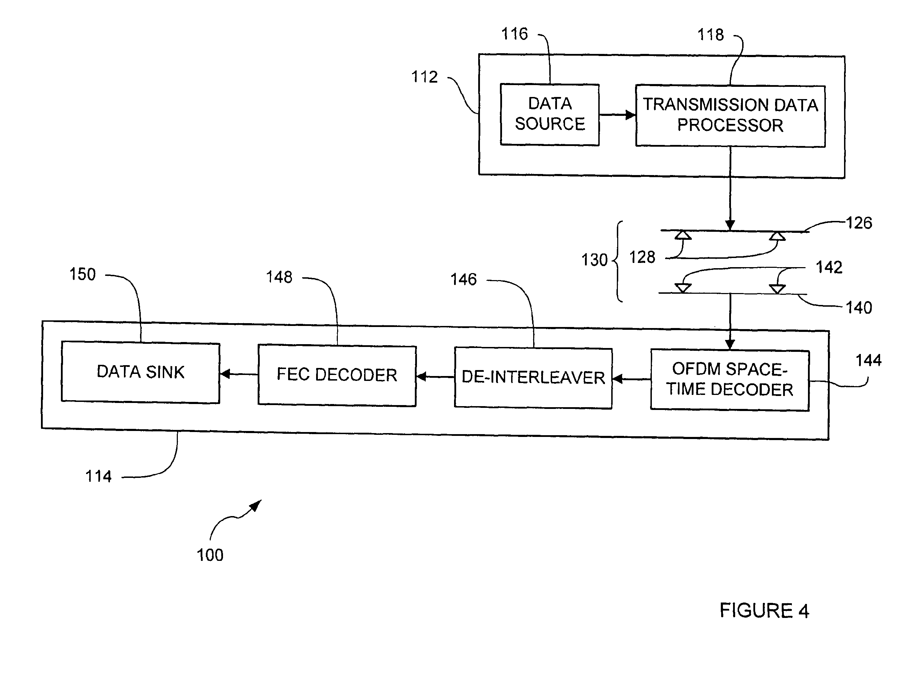

As illustrated in figure 4, a MIMO data communications system 100 in accordance with the specific embodiment of the invention comprises a transmitter device 112 and a receiver device 114.

It will be appreciated that in many circumstances, a wireless communications device will be provided with the facilities of a transmitter and a receiver in combination but, for this example, the devices have been illustrated as one way communications devices for reasons of clarity.

The transmitter device 112 comprises a data source 116, which provides data (comprising information bits) to a transmission data processor 118. The transmission data processor 118 processes data input to it by the data source 116, and presents a multiplexed signal to a transmitter antenna array 126 comprising a plurality of transmit antennas 128. In this illustrated example, two transmit antennas 128 are provided.

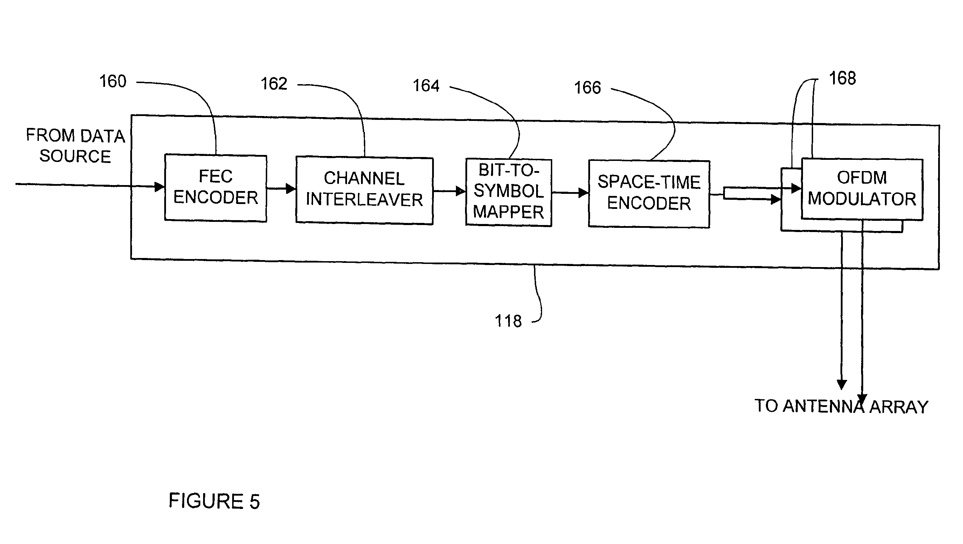

The transmission data processor 118 is illustrated in further detail in figure 5. The processor 118 comprises a FEC encoder 160 and a channel interleaver 162. A bit to symbol mapper 164 maps the interleaved bit stream into symbols, which are passed to a space-time encoder 166 which encodes an incoming symbol or symbols as a plurality of encoded symbols for transmission from multiple antennas.

The encoded transmitted signals propagate through a MIMO channel 130 defined between the transmit antenna array 126 and a corresponding receive antenna array 140 of the receiver device 114. The receive antenna array 140 comprises a plurality of receive antennas 142 which provide a plurality of inputs to a space-time (and/or frequency) decoder 144 of the receiver device 114. In this specific embodiment, the receive antenna array 140 comprises two receive antennas 142.

The receiver 114 comprises an OFDM space-time (ST) decoder 144 which receives signals from the receive antennas and outputs a stream of either detected bits or representations of bits in some alternative form (such as soft bit information e.g. a loglikelihood ratio for each bit). These bits, or their representations, are de-interleaved in a de-interleaver 146 in accordance with a specific embodiment of the invention and then input into an FEC decoder 148. The de-interleaving operation employs knowledge of the bit index permutation applied by the interleaver 162 of the transmitter 112, in order to conduct the reverse permutation of the bit ordering. This means that the order of bits, or their representations, input to the FEC decoder 148 is the same as the order of the bits that was output by the FEC encoder 160.

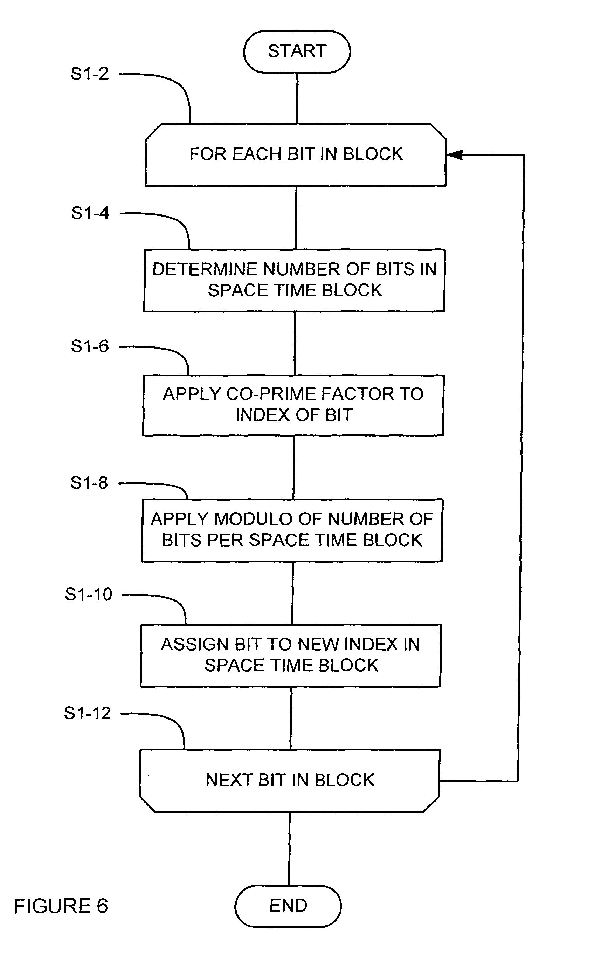

Operation of the channel interleaver 162 will now be described with reference to the flow diagram of figure 6. The process illustrated thereby is executed on receipt of a block of data by the channel interleaver 162. The process ensures that all encoded data bits are interleaved by the interleaver 162 with a block size corresponding to the number of bits input to the space-time block encoder in order to produce a single space-time code block on each data carrying sub-carrier, $N_{BPSTB}$.

The process ensures that adjacent coded bits are mapped in such a way that they fall on different, and usually widely separated, sub-carriers, onto different bit positions within a symbol, and onto different positions within the encoded space-time block. It is desirable that different positions within a space-time block result in the bits being transmitted from different antennas.

In a first step S1-2, a loop is established so that subsequent steps are performed for each bit in the block. Then in step S 1-4, the number of bits per space-time block $N_{BPSTB}$ is determined:

$$N_{BPSTB} = bits\_symb * N\_subs * N\_st\_symb$$

where:

  bits_symb = number of bits per symbol (e.g. 4 for 16QAM)
  N_subs = number of data carrying sub-carriers (e.g. 48)
  N_st_symb = number of input symbols to one space-time block

For example, if the space-time encoder is set for spatial multiplexing transmissions, N_st_symb is the number of transmit antennas. If it is set for Alamouti encoding, N_st_symb is equal to 2, and for conventional transmissions from a single antenna N_st_symb is equal to 1.

Various alternative space-time encoders could be employed, and in particular, N_st_symb does not have to be equal to the number of transmit antennas.

Then, in step S1-6, $N_{BPSTB}$ is multiplied by $\alpha$, a fixed integer value which is implementation dependent as it can be chosen depending on the range of values of $N_{BPSTB}$ may take (specifically, the different values that bits_symb, N_subs or N_st_symb may take). $\alpha$ must be in the range $1 \le \alpha \le N_{BPSTB}$, and also $\alpha$ and $N_{BPSTB}$ must be co-prime (otherwise referred to as being relatively prime). The requirement for two integers to be co-prime is that they share no common positive factors (divisors) except 1. This requirement ensures that all bits input to the interleaver are allocated a unique position in the output sequence.

The design dependent value of $\alpha$ is chosen such that for all required values of $N_{BPSTB}$ the bit permutation resulting from the interleaver places consecutive input bits on different sub-carriers, on different symbol bit positions and on symbols in the space-time encoded block.

In step S1-8, the resultant product is subjected to a modulo operation of base equal to the number of bits per space time block $N_{BPSTB}$. The result of this operation is the new index *i* which is then used in step S 1-10 to reassign the bit to a new position in the block output from the interleaver.

Thus the index *i* is expressed as:

$$i = \alpha*k \bmod N_{BPSTB} \qquad k = 0,1,...,N_{BPSTB} - 1$$

where k is the index of the bit before the application of this algorithm.

Since $N_{BPSTB}$ can often take several values, it is useful to pick $\alpha$ to be a prime number, obviously ensuring that this prime number is not a divisor of any of the values that $N_{BPSTB}$ will take. Examples of suitable values of $\alpha$ that could be chosen are 23 or 37; however, it will be appreciated that many other values could be chosen.

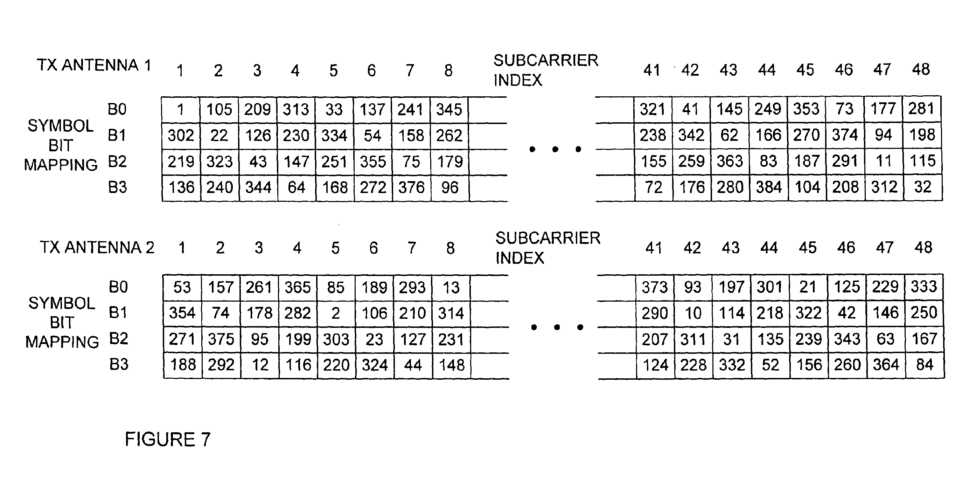

The result of this operation on the bits of the input space time block is a reallocation of bits within the space time block, to sub-carriers of OFDM symbols output on the two antennas. Figure 7 illustrates the reallocation for a system with 2 transmit antennas, 48 data carrying sub-carriers and employing 16QAM - parts of the table have been omitted for reasons of clarity, but the principles governing the interleaving process can be ascertained. It can be seen that, for example, bit number 10 is on antenna 2, subcarrier 42, bit position $b_1$, bit number 11 is on antenna 1, subcarrier 47, bit position $b_2$, and bit number 12 is on antenna 2, subcarrier 3, bit position $b_3$.

Whereas the present invention has been exemplified by a specific embodiment in which the process of determining a permutation of bit arrangements in a space time block is carried out as required during transmission, it would be possible to provide a set of look up tables referable by a transmitter to map bits directly from a non-interleaved position to an interleaved position. Furthermore, the set of look-up tables may be provided to a receiver configured to receive such an interleaved signal, the look-up tables being capable of reference in reverse, to map the interleaved bits back to their un-interleaved positions.

In the event that a transmitter is provided with the facility to transmit in a number of different transmission modes, in which the number of bits transportable in a single OFDM symbol is varied, then look-up tables should be provided to enable selection of the appropriate look up table for the interleaving to be carried out given the number of bits accommodated in an OFDM symbol.

It will be appreciated that a number of implementations of this interleaver are possible, in which the structure of the transmitter is varied or parameters of the interleaver are altered. It is envisaged that these modifications will result in different permutations of the coded bits, but the overall performance of the interleaver derives from the fact that a relatively computationally straightforward interleaver is provided in the present invention.

It will be appreciated that the interleaver of the IEEE 802.11a standard always results in bits being allocated to sub-carriers in exactly the same way, i.e. to every third subcarrier. This ensures that adjacent coded bits always have exactly the same separation. Whilst the co-prime interleaver does not exhibit this feature, by appropriate choice of $\alpha$ it can be ensured that adjacent coded bits always have a minimum separation (e.g. in terms of the number of sub-carriers between them). In most cases, the co-prime interleaver would result in a greater separation between adjacent coded bits than would be achieved using the 802.11a interleaver.

It will be appreciated that the operation to apply a modulo to the product of the existing index and the factor which is co-prime with respect to the number of bits per space time block, can be preceded by the addition of another integer value, which will have the effect of shifting all bits by a predetermined amount within the space time block. Thus, whereas the interleaving operation executed by the interleaver 162 described above is:

$$i = (\alpha * k) \bmod N_{BPSTB}$$

in the alternative, this can be provided as:

$$i = (\alpha * k + \beta) \bmod N_{BPSTB}$$

The effect of this will be to move all permuted bit positions by $\beta$ places.

It will be appreciated that, while the transmitter and receiver described above are specifically configured to operate in accordance with the invention, a general purpose transmitter or general purpose receiver can be configured to operate in this manner by introduction of suitable software to be executed by a computer apparatus. To that end, an aspect of the invention comprises a product, storing computer executable instructions in a computer readable form, which in use causes a computer with suitably configurable hardware components, to operate substantially in accordance with the invention as exemplified by the described embodiment. The product may comprise a storage medium such as an optical disk, a magnetic storage medium or a storage medium of any other technology, an active component such as a removable ROM unit or other memory device such as a memory card, or may comprise a signal such as could be received in a download, the signal bearing data defining such computer readable instructions as to establish a computer executable program product.

The product could also comprise an application specific integrated circuit which, when installed in a suitably configured general purpose device, renders the resultant system operable in accordance with any of the aspects of the invention exemplified by the described embodiments.

The scope of protection claimed in the appended claims is to be determined on the basis of the description, with reference to the accompanying drawings, but not to the extent that features of the specific embodiments of the invention are to be construed as limitations on the scope of features of the claims.

**Claims**

1. Transmitter apparatus (112) for generating a multi-antenna output for transmission into a channel, the apparatus comprising a data source (116) for generating a block of coded bits for transmission in a first configuration, interleaving means (162) for permuting the bits into a second configuration, and modulating means (168) for modulating the bits in said second configuration into an OFDM frame for transmission, the interleaving means (162) comprising mapping means (164) for applying a mapping function to a first value describing the position of a bit in said first configuration, said mapping means (164) being operable to generate a second value describing the position of said bit in said second position, the relationship between the second value and said first value being based on the product of the first value and a factor co-prime with the number of bits in said block of data.

2. Apparatus in accordance with claim 1 and wherein the mapping means is operable to perform a mapping function to determine said second value.

3. Apparatus in accordance with claim 1 and wherein the mapping means is operable to retrieve a second value from a stored set of prepared second values.

4. Apparatus in accordance with claim 3 wherein said stored set is stored in a look-up table.

5. Apparatus in accordance with claim 4 operable to transmit data in accordance with a selected one of a plurality of available transmission modes, each offering the facility to transmit a corresponding number of bits in an OFDM symbol, the apparatus comprising a corresponding plurality of look-up tables, each look-up table storing a set of prepared second values.

6. Apparatus in accordance with any preceding claim wherein the mapping means is operable to apply a modulo to said second value such that said second value is within a range of permitted values for describing said second position.

7. Receiving apparatus (114) for receiving a transmission from multiple transmit antennas transmitted by a transmitter (112) in accordance with any preceding claim, including de-interleaving means (146) capable of de-interleaving data received from a multiple antenna transmission, the de-interleaving means being operable to map second values, identifying the position of a bit in a block of received data, back to first values identifying the position of bits in the block as generated by the transmitting apparatus.

8. Apparatus in accordance with claim 7 wherein the de-interleaving means includes a stored set of first values from which the de-interleaving means is operable to select one on the basis of a bit in a position identified by a second value.

9. Apparatus in accordance with claim 8 wherein the de-interleaving means comprises a look-up table in which said stored set is stored.

10. Apparatus in accordance with claim 8 or claim 9 wherein the de-interleaving means comprises a plurality of look-up tables, each corresponding to a transmission mode, storing respective sets of first values from which one is selected, in use of the de-interleaving means, on the basis of the transmission mode in which received data is received and the second value corresponding to the position of a bit in a block of received data.

11. Communications system comprising a transmitter apparatus (112) in accordance with any of claims 1 to 6 and a receiving apparatus (114) in accordance with any of claims 7 to 10, the transmitter apparatus (112) being capable of transmission from multiple antennas to a receiver with one or more antennas.

12. Communications apparatus comprising a transmitter apparatus (112) in accordance with any of claims 1 to 6 and a receiving apparatus (114) in accordance with any of claims 7 to 10, the communications apparatus being capable of transmitting, by means of said transmitter apparatus (112), a transmission from multiple antennas into a wireless communications channel, and being capable of receiving, by means of said receiver apparatus (114), a transmission from multiple antennas from a wireless communications channel.

13. An interleaver (162) for use in transmitter apparatus (112) for generating a multi-antenna output for transmission into a wireless channel, interleaver (162) being operable to receive a block of coded bits for transmission in a first configuration, to permute the bits into a second configuration, and to output the permuted bits to modulating means for modulating the bits in said second configuration into an OFDM frame for transmission, the interleaving means (162) comprising mapping means (164) for applying a mapping function.to a first value describing the position of a bit in said first configuration, said mapping means (164) being operable to generate a second value describing the position of said bit in said second position, the relationship between the second value and said first value being based on the product of the first value and a factor co-prime with the number of bits in said block of data.

14. An interleaver in accordance with claim 13 and wherein the mapping means is operable to perform a mapping function to determine said second value.

15. An interleaver in accordance with claim 13 and wherein the mapping means is operable to retrieve a second value from a stored set of prepared second values.

16. An interleaver in accordance with claim 15 wherein said stored set is stored in a look-up table.

17. An interleaver in accordance with claim 16 for use in a transmitter operable to transmit data in accordance with a selected one of a plurality of available transmission modes, each offering the facility to transmit a corresponding number of bits in an OFDM symbol, the interleaver comprising a corresponding plurality of look-up tables, each look-up table storing a set of prepared second values.

18. An interleaver in accordance with any of claims 13 to 17 wherein the mapping means is operable to apply a modulo to said second value such that said second value is within a range of permitted values for describing said second position.

19. A de-interleaver (146) for use in receiving apparatus (114) for receiving a transmission from multiple transmit antennas including data interleaved by an interleaver (162) in accordance with any of claims 13 to 18, the de-interleaver (146) being operable to map second values, identifying the position of a bit in a block of received data, back to first values identifying the position of bits in the block as received by the interleaver (162).

20. A de-interleaver in accordance with claim 19 wherein the de-interleaving means includes a stored set of first values from which the de-interleaver is operable to select one on the basis of a bit in a position identified by a second value.

21. A de-interleaver in accordance with claim 20 wherein the de-interleaver comprises a look-up table in which said stored set is stored.

22. A de-interleaver in accordance with claim 20 or claim 21 comprising a plurality of look-up tables, each corresponding to a transmission mode, storing respective sets of first values from which one is selected, in use of the de-interleaver, on the basis of the transmission mode in which received data is received and the second value corresponding to the position of a bit in a block of received data.

23. A method of generating a multi-antenna output for transmission into a wireless channel, comprising generating a block of coded bits for transmission in a first configuration, permuting the bits into a second configuration, and modulating the bits in said second configuration into an OFDM frame for transmission, the step of permuting comprising mapping a first value describing the position of a bit in said first configuration, to a second value describing the position of said bit in said second position, wherein the relationship between the second value and said first value is based on the product of the first value and a factor co-prime with the number of bits in said block of data.

24. A method in accordance with claim 23 and wherein the step of mapping comprises performing a mapping function to determine said second value.

25. A method in accordance with claim 23 and wherein the step of mapping comprises retrieving a second value from a stored set of prepared second values.

26. A method in accordance with claim 25 wherein said stored set is stored in a look-up table.

27. A method in accordance with claim 26 in a transmitter operable to transmit data in accordance with a selected one of a plurality of available transmission modes, each offering the facility to transmit a corresponding number of bits in an OFDM symbol, the method comprising selecting one of a corresponding plurality of look-up tables, each look-up table storing a set of prepared second values.

28. A method in accordance with any of claims 23 to 27 wherein the mapping step comprises applying a modulo to said second value such that said second value is within a range of permitted values for describing said second position.

29. A method of receiving a transmission from multiple transmit antennas transmitted by a transmission method in accordance with any of claims 23 to 28, including de-interleaving data received from a multiple antenna transmission, the step of de-interleaving comprising mapping a second value identifying the position of a bit in a block of received data, to a first value identifying the position of bits in the block as generated by the transmission method.

30. A method in accordance with claim 29 wherein the step of de-interleaving includes selecting one of a stored set of first values on the basis of a bit in a position identified by a second value.

31. A method in accordance with claim 30 wherein said stored set is stored in a look-up table.

32. A method in accordance with claim 30 or claim 31 wherein the step of de-interleaving comprises selecting a look-up table, from a plurality of look-up tables, each corresponding to a transmission mode and storing respective sets of first values, on the basis of the transmission mode in which received data is received and determining a first value corresponding to the position of said bit in said first configuration as generated in said transmission method, from said selected look-up table on the basis of the second value corresponding to the position of said bit in a block of received data.

33. A method of communicating comprising transmitting data in accordance with the method of any of claims 23 to 28 and receiving data in accordance with the method of any of claims 29 to 32.

34. A method of interleaving data generated as a block of bits for transmission from multiple antennas into a wireless channel, the block of coded bits being generated in a first configuration, the method comprising permuting the bits into a second configuration prior to their modulation in said second configuration into an OFDM frame for transmission, the step of permuting comprising mapping a first value describing the position of a bit in said first configuration, to a second value describing the position of said bit in said second position, wherein the relationship between the second value and said first value is based on the product of the first value and a factor co-prime with the number of bits in said block of data.

35. A method in accordance with claim 34 and wherein the step of mapping comprises performing a mapping function to determine said second value.

36. A method in accordance with claim 34 and wherein the step of mapping comprises retrieving a second value from a stored set of prepared second values.

37. A method in accordance with claim 36 wherein said stored set is stored in a look-up table.

38. A method in accordance with claim 37 for use in a transmitter operable to transmit data in accordance with a selected one of a plurality of available transmission modes, each offering the facility to transmit a corresponding number of bits in an OFDM symbol, the method comprising selecting one of a corresponding plurality of look-up tables, each look-up table storing a set of prepared second values.

39. A method in accordance with any of claims 34 to 38 wherein the mapping step comprises applying a modulo to said second value such that said second value is within a range of permitted values for describing said second position.

40. A method of de-interleaving data from a multiple antenna transmission the data having been interleaved by a method in accordance with any of claims 34 to 39, including de-interleaving data received from a multiple antenna transmission, the method of de-interleaving comprising mapping a second value identifying the position of a bit in a block of received data, to a first value identifying the position of bits in the block as generated by the transmission method.

41. A method in accordance with claim 40 including selecting one of a stored set of first values on the basis of a bit in a position identified by a second value.

42. A method in accordance with claim 41 wherein said stored set is stored in a look-up table.

**43.** A method in accordance with claim 41 or claim 42 wherein the step of de-interleaving comprises selecting a look-up table, from a plurality of look-up tables, each corresponding to a transmission mode and storing respective sets of first values, on the basis of the transmission mode in which the data had been transmitted, and determining a first value corresponding to the position of said bit in said first configuration as generated in said transmission method, from said selected look-up table on the basis of the second value corresponding to the position of said bit in a block of received data.

**44.** A computer program product, carrying processor executable instructions which, when executed by a computer, cause said computer to become configured as a transmitter in accordance with any of claims 1 to 6.

**45.** A computer program product, carrying processor executable instructions which, when executed by a computer, cause said computer to become configured as a receiver in accordance with any of claims 7 to 10.

**46.** A computer program product, carrying processor executable instructions which, when executed by a computer, cause said computer to become configured as an interleaver in accordance with any of claims 13 to 18.

**47.** A computer program product, carrying processor executable instructions which, when executed by a computer, cause said computer to become configured as a de-interleaver in accordance with any of claims 19 to 22.

**48.** A computer program product, carrying processor executable instructions which, when executed by a computer, cause said computer to perform a method of transmitting a signal in accordance with any of claims 23 to 28.

**49.** A computer program product, carrying processor executable instructions which, when executed by a computer, cause said computer to perform a method of receiving a signal in accordance with any of claims 29 to 32.

**50.** A computer program product, carrying processor executable instructions which, when executed by a computer, cause said computer to perform a method of interleaving data in accordance with any of claims 34 to 39.

**51.** A computer program product, carrying processor executable instructions which, when executed by a computer, cause said computer to perform a method of de-interleaving data in accordance with any of claims 40 to 43.

**52.** A signal bearing data defining processor executable instructions which, when received in and executed by a computer, cause said computer to become configured as a transmitter in accordance with any of claims 1 to 6.

**53.** A signal bearing data defining processor executable instructions which, when received in and executed by a computer, cause said computer to become configured as a receiver in accordance with any of claims 7 to 10.

**54.** A signal bearing data defining processor executable instructions which, when received in and executed by a computer, cause said computer to become configured as an interleaver in accordance with any of claims 13 to 18.

**55.** A signal bearing data defining processor executable instructions which, when received in and executed by a computer, cause said computer to become configured as a de-interleaver in accordance with any of claims 19 to 22.

**56.** A signal bearing data defining processor executable instructions which, when received in and executed by a computer, cause said computer to perform a method of transmitting a signal in accordance with any of claims 23 to 28.

**57.** A signal bearing data defining processor executable instructions which, when received in and executed by a computer, cause said computer to perform a method of receiving a signal in accordance with any of claims 29 to 32.

**58.** A signal bearing data defining processor executable instructions which, when received in and executed by a computer, cause said computer to perform a method of interleaving data in accordance with any of claims 34 to 39.

**59.** A signal bearing data defining processor executable instructions which, when received in and executed by a computer, cause said computer to perform a method of de-interleaving data in accordance with any of claims 40 to 43.

FIGURE 1

EP 1 608 075 A2

| SYMBOL BIT MAPPING | 1 | 2 | 3 | 4 | 5 | 6 | 7 | 8 | SUBCARRIER INDEX | 41 | 42 | 43 | 44 | 45 | 46 | 47 | 48 |
|---|---|---|---|---|---|---|---|---|---|---|---|---|---|---|---|---|---|
| b0 | 1 | 65 | 129 | 18 | 82 | 146 | 3 | 67 | • • • | 94 | 158 | 15 | 79 | 143 | 32 | 96 | 160 |
| b1 | 17 | 81 | 145 | 2 | 66 | 130 | 19 | 83 | | 78 | 142 | 31 | 95 | 159 | 16 | 80 | 144 |
| b2 | 33 | 97 | 161 | 50 | 114 | 178 | 35 | 99 | | 126 | 190 | 47 | 111 | 175 | 64 | 128 | 192 |
| b3 | 49 | 113 | 177 | 34 | 98 | 162 | 51 | 115 | | 110 | 174 | 63 | 127 | 191 | 48 | 112 | 176 |

FIGURE 2

FIGURE 3

116

118

112

DATA
SOURCE

TRANSMISSION DATA
PROCESSOR

126

130 { 128

142

140

150

148

146

144

DATA SINK

FEC DECODER

DE-INTERLEAVER

OFDM SPACE-
TIME DECODER

114

100

FIGURE 4

FIGURE 5

EP 1 608 075 A2

```
            ┌──────────┐
            │  START   │
            └────┬─────┘
                 │
S1-2 ────┐       │
    ┌────────────────────────────────┐◄──────┐
    │     FOR EACH BIT IN BLOCK       │       │
    └──────────────┬─────────────────┘       │
                   │                          │
S1-4 ────┐         │                          │
    ┌──────────────────────────────┐          │
    │ DETERMINE NUMBER OF BITS IN   │          │
    │    SPACE TIME BLOCK           │          │
    └──────────────┬───────────────┘          │
                   │                          │
S1-6 ────┐         │                          │
    ┌──────────────────────────────┐          │
    │ APPLY CO-PRIME FACTOR TO      │          │
    │    INDEX OF BIT               │          │
    └──────────────┬───────────────┘          │
                   │                          │
S1-8 ────┐         │                          │
    ┌──────────────────────────────┐          │
    │ APPLY MODULO OF NUMBER OF     │          │
    │ BITS PER SPACE TIME BLOCK     │          │
    └──────────────┬───────────────┘          │
                   │                          │
S1-10 ───┐         │                          │
    ┌──────────────────────────────┐          │
    │ ASSIGN BIT TO NEW INDEX IN    │          │
    │    SPACE TIME BLOCK           │          │
    └──────────────┬───────────────┘          │
                   │                          │
S1-12 ───┐         │                          │
    ┌──────────────────────────────┐          │
    │      NEXT BIT IN BLOCK        │──────────┘
    └──────────────┬───────────────┘
                   │
            ┌──────────┐
            │   END    │
            └──────────┘
```

FIGURE 6

TX ANTENNA 1

| | SUBCARRIER INDEX | | | | | | | | | | | | | | | | | |
|---|---|---|---|---|---|---|---|---|---|---|---|---|---|---|---|---|---|---|
| | 1 | 2 | 3 | 4 | 5 | 6 | 7 | 8 | | 41 | 42 | 43 | 44 | 45 | 46 | 47 | 48 |
| B0 | 1 | 105 | 209 | 313 | 33 | 137 | 241 | 345 | | 321 | 41 | 145 | 249 | 353 | 73 | 177 | 281 |
| B1 | 302 | 22 | 126 | 230 | 334 | 54 | 158 | 262 | ... | 238 | 342 | 62 | 166 | 270 | 374 | 94 | 198 |
| B2 | 219 | 323 | 43 | 147 | 251 | 355 | 75 | 179 | | 155 | 259 | 363 | 83 | 187 | 291 | 11 | 115 |
| B3 | 136 | 240 | 344 | 64 | 168 | 272 | 376 | 96 | | 72 | 176 | 280 | 384 | 104 | 208 | 312 | 32 |

SYMBOL BIT MAPPING

TX ANTENNA 2

| | SUBCARRIER INDEX | | | | | | | | | | | | | | | | | |
|---|---|---|---|---|---|---|---|---|---|---|---|---|---|---|---|---|---|---|
| | 1 | 2 | 3 | 4 | 5 | 6 | 7 | 8 | | 41 | 42 | 43 | 44 | 45 | 46 | 47 | 48 |
| B0 | 53 | 157 | 261 | 365 | 85 | 189 | 293 | 13 | | 373 | 93 | 197 | 301 | 21 | 125 | 229 | 333 |
| B1 | 354 | 74 | 178 | 282 | 2 | 106 | 210 | 314 | ... | 290 | 10 | 114 | 218 | 322 | 42 | 146 | 250 |
| B2 | 271 | 375 | 95 | 199 | 303 | 23 | 127 | 231 | | 207 | 311 | 31 | 135 | 239 | 343 | 63 | 167 |
| B3 | 188 | 292 | 12 | 116 | 220 | 324 | 44 | 148 | | 124 | 228 | 332 | 52 | 156 | 260 | 364 | 84 |

SYMBOL BIT MAPPING

FIGURE 7

EP 1 608 075 A2